(19) **Europäisches Patentamt / European Patent Office / Office européen des brevets**

(11) **EP 1 058 949 B1**

(12) **EUROPEAN PATENT SPECIFICATION**

(45) Date of publication and mention
of the grant of the patent:
**21.05.2008 Bulletin 2008/21**

(51) Int Cl.:
*H01L 29/423* (2006.01)   *H01L 29/43* (2006.01)
*H01L 29/739* (2006.01)   *H01L 29/417* (2006.01)
*H01L 29/06* (2006.01)

(21) Application number: **99904324.3**

(22) Date of filing: **28.01.1999**

(86) International application number:
**PCT/US1999/001715**

(87) International publication number:
**WO 1999/040629 (12.08.1999 Gazette 1999/32)**

(54) **RF MOS TRANSISTOR**

RF-MOS-TRANSISTOR

TRANSISTOR RF MOS

(84) Designated Contracting States:
**AT BE CH CY DE DK ES FI FR GB GR IE IT LI LU MC NL PT SE**

(30) Priority: **07.02.1998 US 20257**
**07.02.1998 US 20256**

(43) Date of publication of application:
**13.12.2000 Bulletin 2000/50**

(73) Proprietor: **Sirenza Microdevices, Inc.**
**Broomfield, CO 80021 (US)**

(72) Inventors:
• **JOHNSON, Joseph, H.**
**Sunnyvale, CA 94087 (US)**
• **D'ANNA, Pablo, E.**
**Los Altos, CA 94024 (US)**

(74) Representative: **Käck, Jürgen et al**
**Patentanwälte**
**Kahler Käck Mollekopf**
**Vorderer Anger 239**
**86899 Landsberg (DE)**

(56) References cited:
**WO-A-99/28976**   **DE-A- 19 801 095**
**US-A- 4 408 384**   **US-A- 4 682 405**
**US-A- 4 803 539**   **US-A- 5 155 563**

• **PATENT ABSTRACTS OF JAPAN vol. 007, no. 233 (E-204), 15 October 1983 (1983-10-15) & JP 58 122780 A (SHARP KK), 21 July 1983 (1983-07-21)**
• **PATENT ABSTRACTS OF JAPAN vol. 012, no. 277 (E-640), 30 July 1988 (1988-07-30) & JP 63 055960 A (HITACHI LTD;OTHERS: 01), 10 March 1988 (1988-03-10)**
• **CROS A., "Formation, Oxidation, Electronic and Electrical Properties of Copper Silicides", J. APPL. PHYS., 1 April 1990, Vol. 67, No. 7, pages 3328-3336, XP002918093**

**Description**

BACKGROUND ART

Power high frequency devices have been built using a variety of semiconductor technologies. For a long time the preferred vehicle for their realization has been the NPN bipolar junction transistor (BJT). Its primary advantage was the achievable high intrinsic transconductance ($g_m$) that permitted the fabrication of high power devices utilizing small silicon areas.

As processing technology improved, in the early 1970's a number of MOSFET vertical structures begun to challenge the dominance of the BJT at the lower RF frequencies, trading the cost of the large silicon area, necessary to provide the current capability in MOSFETs, for the cost of simple processing. The advantages that the MOSFET structure provided to the user were: higher power gain, ruggedness (defined as the capacity to withstand transients) and ease of biasing.

In the continuous quest for high frequency operation at high power the MOSFET structure has displaced the BJT since the early 1970's in applications where its performance has been competitive.

Recently, new prior art RF MOS devices have been placed on the market by several vendors. The new prior art RF MOS devices utilize the standard lateral MOS device with a diffused via that connects the source to the backside of the chip such that the back side becomes both electrical and thermal ground. The prior art structure also uses a polysilicide gate process as a compromise between the fabrication benefits of the self aligned polysilicon gate and the high frequency performance of the metal gate structure. The prior art structure has extended the frequency of operation of MOS devices into the 2 GHz region thus covering two frequency bands of great commercial importance: the cellular and PCS/PCN mobile telephone bands.

The via backside contact design and the polysilicide gate processing technology have allowed the prior art device to attain its performance. Firstly, by transferring the source connection to the backside of the chip through a diffused via, the packaging of the device has been simplified reducing parasitic inductance and resistance to ground. The thermal dissipation has been also improved because an electrical isolation layer in the package has been removed. Secondly, the output capacitance of RF MOS device for the common-source mode of amplification operation has been made comparable to the output capacitance obtained with BJT structures. This results in improved collector efficiency and in wider usable bandwidth (BW) of the RF MOS device operating as an amplifier. This improvement comes about as the lateral RF MOS device at high drain-source applied bias has a lower drain -source capacitance ($C_{ds}$) than the drain -source capacitance of the prior art RF MOS devices. Finally, the use of polysilicide allows the efficient feeding of long gate fingers.

In terms of horizontal geometry, the prior art bipolar junction transistor (BJT) used two basic geometries: the interdigitated geometry and the mesh geometry. The interdigitated BJT structure is a set of parallel rows of emitters stripes placed inside a base area. The mesh geometry is similar to the interdigitated but includes connections between emitter stripes.

Traditionally, the RF MOS transistor had the BJT interdigitated horizontal geometry with polysilicon fingers (gate), drain contact in the middle, and the source on both sides. In this geometry, the current moves from the source (from the bottom) to the drain under the gate. The problem with this structure is that the current had to feed a very long and narrow gate. The ratio of the length of the gate (50-100) $\mu$ to the width of the gate (1 $\mu$) was about (50-100). Of course, all portions of a metal gate with the resistivity per square of 0.1 ($\Omega$/square) could be fed very efficiently up to very high frequencies. But, for the prior art polysilicon gate fingers with (50-100 squares) and with the resistivity per square of (20 $\Omega$/square), the resistivity was too high 20 x 100 = 2,000 $\Omega$, so that different portions of the gate were not fed equally. Depending on the frequency and the resistivity of the material, some portions of the gate were not used at all.

One solution to this problem is to put silicide on the polysilicon gate finger, that is to put metal like tungsten (Tg), titanium (Ti), cobalt (Co), or platinum (Pl) on the polysilicon. If high enough temperature is applied, the metal and the polysilicon mix and form the silicide. The resistivity per square of the silicided gate is significantly decreased comparatively with the polysilicon gate. Indeed, the resistivity per square for the tungsten silicided gate is (2 $\Omega$/square), for the titanium silicided gate is 1 ($\Omega$/square), for the cobalt silicided gate is (1-2) ($\Omega$/square), and for the platinum silicided gate is (1-2) ($\Omega$/square).

The silicided gate is adequate for a broad range of frequencies. For instance, the silicided gate fingers in the prior art RF MOS devices could be fed very efficiently at cellular 900 MHz frequencies. However, at higher frequencies, in the range of 2 GHz needed for operation of the personal communication services devices (PCS), the long silicided gate is still not adequate because it can not be fed equally. In addition, at high frequencies about 2 GHz, the long fingers have not only a resistive component, but also a sizable capacitance component, that is, the gate acts as a voltage divider.

US 4,408,384 discloses a method for fabricating insulated gate field effect transistors having a direct metal connection between the backside of a substrate and a source region. The direct metal connection has a V-shaped cross-section 35 and is formed by using an anisotropic wet chemical etching process which has a fast etch rate on (100) silicon planes but a very slow etch rate on (111) plane. The V-shaped cross-section has approximately the same dimensions in width and in depth (equi-sided triangular).

The power FET for RF applications proposed in US 5,155,563 is fabricated on an epitaxial layer as semiconductor material. First to fifth regions are formed thereon and a heavy doped first region is formed having a direct contact to the substrate which bridges the n-type doped fifth region to the substrate. This first region is made by using a diffusion process which is isotropic in Silicon material.

In US 4,803,539 different metals are deposited on a Si substrate and metal silicides are formed by tempering.

Patent Abstract of Japan JP 63 055960 A shows a plug running from the source region to the low-resistant substrate and having a high ratio of depth-to-width dimension.

It is an object of the invention to provide RF MOS transistors having improved conductive connections within the semiconductor material and requiring a reduced horizontal space.

The invention is defined in claim 1.

Particular embodiments are set out in the dependent claims.

According to the invention the connection from the source to the backside of the silicon substrate is improved with a metal plug thus reducing the space needed for that connection. In the fabrication of the existing RF MOS devices, source to backside via diffusion moves laterally as well as downward, wherein a metal plug can be made deep and narrow. The metal plug design would allow inclusion of more usable device active area per unit chip area, increase of available device output power per unity chip area, further decrement of the minimal value of the drain -source capacitance ($C_{ds}$), and in wider usable BW of the device operating as an amplifier.

The present invention is directed to a lateral MOS structure having a plug connecting the contact region at the chip surface to its backside.

In the first preferred embodiment, the lateral MOS structure comprises a semiconductor material of a P-type having a first dopant concentration $P^{--}$ and a top surface. An enhanced drain drift region of an N conductivity type having a dopant concentration N is formed completely within the semiconductor material. A drain region of an N conductivity type having a dopant concentration $N^+$ is formed in the semiconductor material. The conductive gate structure is insulated from the top surface of the semiconductor material by an oxide portion, which in turn overlies the N enhanced region.

In an embodiment, the lateral MOS structure comprises a semiconductor material of a P-type having a first dopant concentration $P^{--}$ and a top surface. An enhanced drain drift region of an N conductivity type having a dopant concentration N is formed completely within the semiconductor material. A drain region of an N conductivity type having a dopant concentration $N^+$ is formed in the semiconductor material. The conductive gate is insulated from the top surface of the semiconductor material by an oxide portion, which in turn overlies the N enhanced region. The N enhanced region extends between the N drain region and the conductive gate. A body region of P conductivity type is formed in semiconductor material of the lateral MOS structure. The body region has a dopant concentration P that is equal or greater than the first dopant concentration $P^{--}$. The body region includes a first end underlying the conductive gate. The remaining portion of the semiconductor material of the first conductivity type P underlies the gate. A fourth region of the second conductivity type N is formed in the semiconductor material. The fourth region is located within the body region. The fourth region forms a source region of the lateral MOS structure. A fifth region of the first conductivity type P is also formed in the semiconductor material. The fifth region having a dopant concentration $P^+$ forms a body contact enhancement region of the lateral MOS structure. The dopant concentration of the fifth region $P^+$ is greater than the dopant concentration P of the body region. The fifth region is located within the body region.

A sixth region of the first conductivity type P is additionally formed in the semiconductor material. The sixth region having a dopant concentration $P^+$ forms a contact region of the lateral MOS structure. The sixth region contacts the body region to a highly conductive substrate of the lateral MOS structure. Finally, a conductive plug region is formed in the semiconductor material. The conductive plug region connects a backside of the semiconductor material to the sixth region of the lateral MOS structure.

In one embodiment of the lateral MOS structure, the dopant concentration $N^+$ of the fourth region is equal to the dopant concentration $N^+$ of the drain region.

The conductive plug can comprise: a metal plug, or a silicided plug. The silicided metal plug can comprise: a tungsten silicided plug, a titanium silicided plug, a cobalt silicided plug, or a platinum silicided plug.

BRIEF DESCRIPTION OF THE DRAWINGS

FIG. 1A shows an idealized NMOS device cross section with depletion and induced channel and with applied positive $V_{GS}$.
FIG. 1B is a small-signal MOS transistor equivalent circuit.
FIG. 1C is an illustration of the prior art structure of lateral RF MOS devices.

FIG. 1D depicts a lateral view of a simplified plug contact structure of a lateral RF MOS transistor.

FIG. 1E depicts a detailed lateral view of the plug contact structure of a lateral RF MOS transistor.

FIG. 2 illustrates a lateral view of a plug contact structure, wherein the conductive plug region connects a top surface and a lateral surface of the source region of the semiconductor material to a highly conductive substrate of the MOS structure.

FIG. 3 is a lateral view of the MOS structure, wherein a V-shaped conductive plug region connects a top surface and a lateral surface of the source region of the semiconductor material to a backside of the MOS structure.

FIG. 4 depicts a lateral view of the MOS structure, wherein an X-shaped conductive plug region connects a top surface and a lateral surface of the source region of the semiconductor material to a backside of the MOS structure.

FIG. 5 is a lateral view of the MOS structure according to the invention, wherein the conductive plug region connects a backside of the semiconductor material to the diffusionally formed source region of the MOS structure.

FIG. 6A illustrates a cross-sectional view of an element of the quasi-mesh structure of a lateral RF MOS device which does not form part of the claimed invention as such, including a plug connection between a source and a backside

FIG. 6B depicts a top view of a quasi-mesh structure of the RF MOS device of the present invention showing a plurality of drain regions, a plurality of source regions including a plurality of conductive plugs, and a conductive gate.

FIG. 7 illustrates an actual top view of the quasi-mesh structure of the RF MOS device showing how a first plurality of metal fingers connect each drain region and how a second plurality of metal fingers connect each gate contact.

FIG. 8 depicts an actual top view of the complete RF MOS transistor array.

BEST MODE FOR CARRYING OUT THE INVENTION

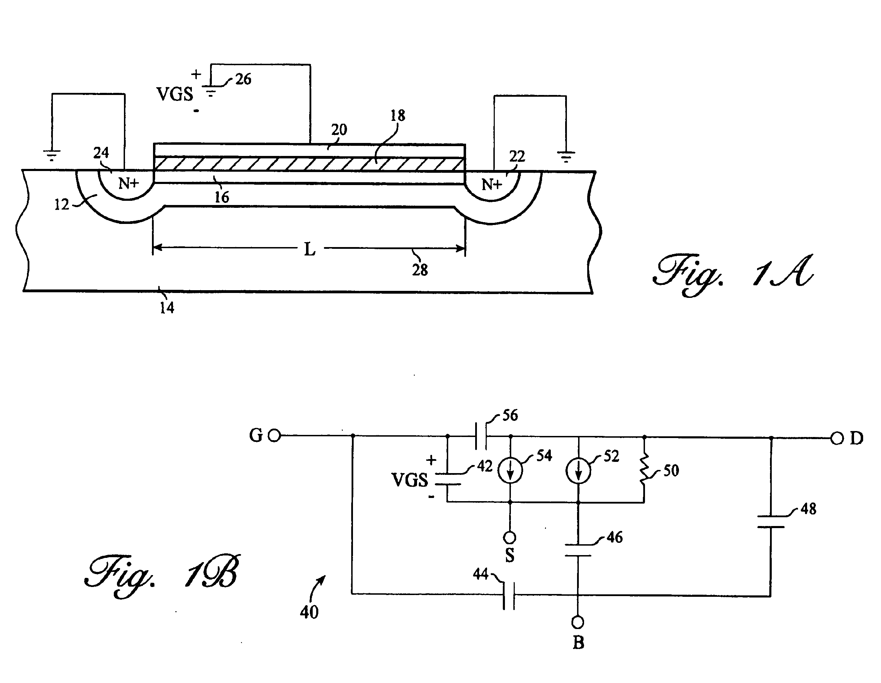

An idealized NMOS device cross section with depletion and induced channel and with applied positive $V_{GS}$ is shown in FIG. 1A. For the complete reference, please, see "Analysis and Design of Analog Integrated Circuits" by Paul Gray and Robert Meyer, published by John Wiley & Sons, Inc., 1993.

In the large-signal model of a typical NMOS device, we consider substrate, source, and drain grounded and a positive voltage $V_{GS}$ (between the gate (20) and the substrate (14)) applied to the gate as shown in FIG. 1A. The gate and the substrate form the plates of a capacitor with the layer of silicon oxide ($SiO_2$) (18) as a dielectric. Positive charge accumulates on the gate and negative charge in the substrate. Initially, the negative charge in the P-type substrate is manifested by creation of a depletion region (12) and resulting exclusion of holes under the gate. The depletion -layer width X under the oxide is:

$$X = (2\epsilon\phi/qN_A)^{1/2}; \qquad (1)$$

where $\phi$ is the potential in the depletion layer at the oxide-silicon interface, $N_A$ (atoms/cm$^3$) is the doping density (assumed constant) of the p-type substrate, and $\epsilon$ is the permittivity of the silicon. The charge per unit area in this depletion region is

$$Q = qN_A X = \sqrt{(2qN_A\epsilon\phi)}. \qquad (2)$$

When the potential in the silicon reaches a critical value equal to twice the Fermi level $\phi_f \sim 0.3$ V, a phenomena known as "inversion" occurs. Further increases in gate voltage produce no further changes in the depletion-layer width but instead a thin layer of electrons is induced in the depletion layer directly under the oxide. This produces a continuous n-type region (16) with the source (24) and drain (22) regions and is the conducting channel between source and drain. The channel (16) can be modulated by increases or decreases in the gate voltage. In the presence of an inversion layer, and with no substrate bias, the depletion region contains a fixed charge:

$$Q_{b0} = \sqrt{(2qN_A\epsilon\phi_f)}. \qquad (3)$$

If a substrate bias voltage $V_{SB}$ (source is positive for n-channel devices) is applied between source and substrate, the potential required to produce inversion becomes $(2\phi_f + V_{SB})$ and the charge stored in the depletion region in general is:

$$Q_b = \sqrt{(2qN_A\epsilon(2\phi_f + V_{SB}))}. \qquad (4)$$

The gate voltage $V_{Gs}$, required to produce an inversion layer, is called the threshold voltage $V_t$ and can be calculated as follows. This voltage consists of several components. First, a voltage $[2\phi_f + (Q_b/C_{0x})]$ is required to sustain the depletion layer charge $Q_b$, where $C_{0x}$ is the gate oxide capacitance per unit area. Second, a work-function difference $\phi_{ms}$ exists between the gate metal and the silicon. Third, there is always charge density $Q_{ss}$ (positive) in the oxide at the silicon interface. This is caused by crystal discontinuities at the Si-SiO$_2$ interface and must be compensated by a gate voltage contribution of (-) $Q_{SS}/C_{0x}$. Thus, we have a threshold voltage:

$$V_t \quad = \phi_{ms} + 2\phi_f + (Q_b/C_{ox}) - Q_{SS}/C_{ox}$$
$$= V_{t0} + \gamma(\sqrt{2\phi_f + V_{SB}} - \sqrt{2\phi_f}); \qquad (5)$$

where $\gamma = (1/C_{0x})\sqrt{2qN_A\epsilon}$, $C_{0x} = \epsilon_{0x}/t_{0x}$, and $\epsilon_{0x}$ and $t_{0x}$ are the permittivity and thickness of the oxide, respectively.

The preceding large-signal equations can be used to derive the small-signal model of the MOS transistor in the saturation or pinch-off region. The source-substrate voltage $V_{BS}$ affects threshold voltage $V_t$ (eq. 5) and thus the drain current $I_D$. This is due to influence of the substrate acting as a second gate and is called *body effect*. As a consequence, the drain current $I_D$ is a function of both $V_{GS}$ and $V_{BS}$, and two transconductance generators (54) and (52) are needed in the small-signal model (40) as shown in FIG. 1B. Variations in voltage $v_{bs}$ from source to body cause current $g_{mb}v_{bs}$ to flow from drain to source. The substrate of this idealized lateral MOS device is the area that we call "body region" in the lateral RF MOS device and is always connected to the most negative supply voltage and is thus an ac ground. Thus, in the present embodiments the "body" effect has no role.

Parasitic resistances due to the channel contact regions should be included in series with the source and drain of the model. These resistances have an inverse dependence on channel width W and have typical values of 50 to 100 $\Omega$ for devices with W of about 1 $\mu$.

The parameters of the small signal model (40) of FIG 1B can be determined from the I-V characteristics of the NMOS device. For voltages between drain and substrate $V_{DS}$ low in comparison with the Early voltage $V_A$, the transconductance $g_m$ is:

$$g_m = \sqrt{2k'}(W/L) I_D; \qquad (6)$$

where $k' = \mu_n C_{0x}$, $\mu_n$ is the average electron mobility in the channel, L and W are the length and the width of the channel. Thus, like the JFET and unlike the bipolar transistor, the transconductance of the MOS depends on both bias current and the W/L ratio (and also on the oxide thickness via k').

Similarly, the transconductance $g_{mb}$ (52) can be expressed as follows:

$$g_{mb} = [\gamma\sqrt{2k'}(W/L) I_D / (\sqrt{2(2\phi_f + V_{SB})})]. \qquad (7)$$

The small-signal output resistance $r_0$ (50) can be expressed as follows:

$$r_0 = (\partial I_D / \partial V_{DS})^{-1} = (V_A / I_D). \qquad (8)$$

The gate-source capacitance $C_{gs}$ (42) of FIG. 1B is intrinsic to the device operation in the saturation region. On the other hand, the substrate-source capacitance $C_{sb}$ (46) is shorted by a metal finger in the prior art device or by the source plug in the present invention structure, and the drain-source capacitance $C_{db}$ (48) is a parasitic depletion-region capacitance equal to the drain -source $C_{ds}$ capacitance. Therefore, for the lateral RF MOS structure:

$$C_{sb} = 0; \qquad\qquad (9)$$

and

$$C_{db} = C_{db0} \; / \; (\sqrt{(1+ V_{DB}/\phi_0 \;\;)})=C_{ds0} \; / \; (\sqrt{(1+ V_{DB}/\phi_0 \;\;)})=C_{ds}. \; (10)$$

The high frequency gain of the lateral RF MOS device is controlled by the capacitance elements in the equivalent circuit. The frequency capability of the lateral RF MOS device is most often specified in practice by determining the frequency where the magnitude of the short-circuit, common gate current gain falls to unity. This is called the transition frequency, $f_T$, and is a measure of the maximum useful frequency of the transistor when it is used as an amplifier.
The $f_T$ of the lateral RF MOS is given by:

$$f_T = (1/2\pi) \; g_m / \; (C_{gs} + C_{gd}). \qquad\qquad (11)$$

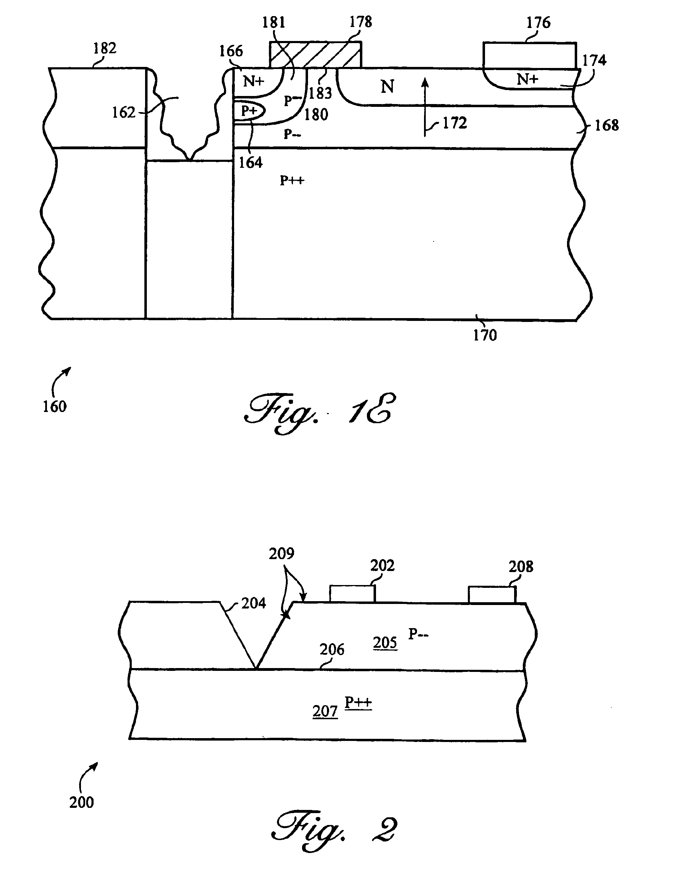

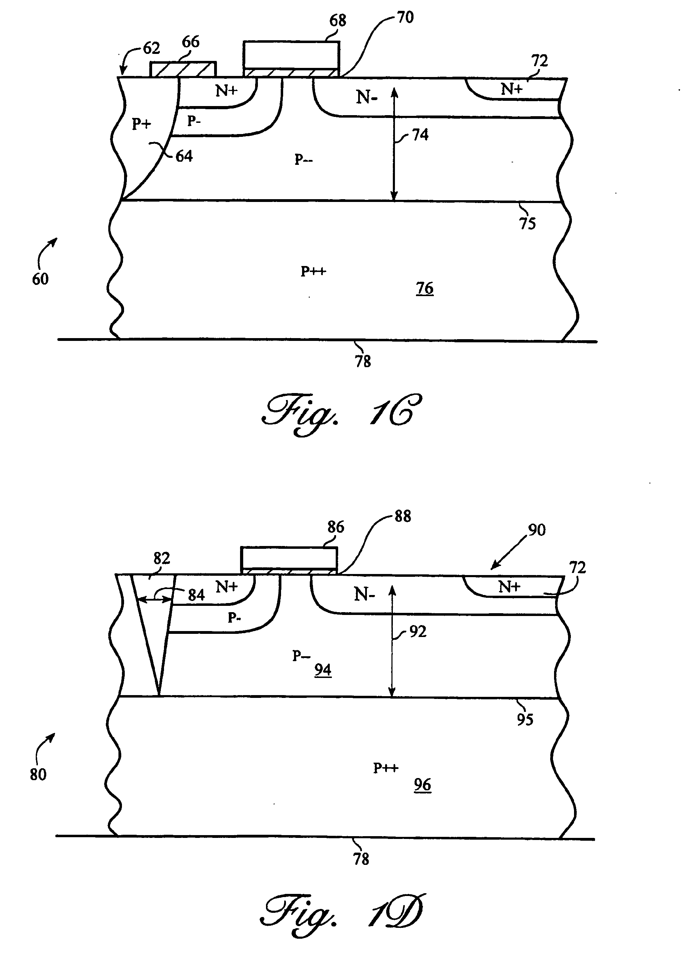

The prior art structure (60) depicted in FIG. 1C illustrates one technique to make a connection of the source and body regions in the MOS structure to the backside (78) through the diffusion of a dopant (64) introduced from the topside (62) of the chip and a metal finger short. However, this diffusion not only moves the topside dopant (64) down and sideways but also moves the substrate dopant (76) up thus reducing the distance between the highly doped substrate interface (75) and the drain area (72) of the device. This diffusion movement of the interface (75) produces an increase of the minimum source-drain capacitance $C_{ds}$ that can be obtained under a high voltage bias $V_{DS}$.
On the other hand, FIG. 1D which serves for understanding the invention illustrates a simplified the plug structure (80). The plug (82) connects the source and the body areas to the backside (95) through the original epitaxial layer (94) thickness without diffusion. The connection area (84 of FIG. 1D) can be made small comparable to the prior art diffusion area (66 of FIG. 1C). Thus, one can increase the density of devices per inch$^2$.
The usage of a metal plug (82 of FIG. 1D) takes care of two important prior art technological problems: (1) how to make a good ohmic contact in a small area (2) without long thermal processing cycles. As it is well known in the art, the long thermal processing cycles increase the doping movements and thus, would increase the source-drain capacitance $C_{ds}$ in the present configuration.
The detailed source-body connection structure (160) for lateral RF MOS devices of the present invention is shown in FIG. 1E. The structure (160) can be used at high frequency applications, such as the cellular and the PCS regions of the RF spectrum.
As was stated above (eq. 11), the principal parameters that need to be optimized in the design of a high frequency, high power lateral RF MOS transistor are: the transconductance $g_m$ and the interelectrode capacitances $C_{gs}$, $C_{gd}$, and $C_{ds}$.
In the plug structure of the present invention, the transconductance per unit $g_m$ is increased by fabricating the device with the smallest plug size that the technology would allow.
The reduction of the interelectrode capacitance (mainly $C_{gd}$ and $C_{db}$) affects gain and efficiency. The gate-drain capacitance $C_{gd}$ (56 of FIG. 1B) and the source-drain capacitance $C_{db}$ (48 of FIG. 1B) are proportional to the gate and drain region areas (including sidewalls). Therefore, the reduction in $C_{gd}$ capacitance can be obtained by minimizing the channel length L and by minimizing the insertion of the drain extension lateral diffusion under the gate. The reduction in $C_{ds}$ capacitance can be obtained by utilizing a high resistivity material under the drain portion of the structure and by separating the drain area from the source.
FIG. 1E depicts a detailed cross-sectional view of the lateral RF MOS transistor having a plug source-body-contact structure. The device structure (160) comprises: a semiconductor material comprising an epitaxial layer (168) of a first conductivity type and having an epitaxial layer dopant concentration and a top surface (182). In one embodiment, the epitaxial layer's conductivity type is P-type, that is the majority carriers are holes. The dopant concentration of the epitaxial layer is P$^{--}$, wherein (--) indicates that the dopant concentration P$^{--}$ of holes in the epitaxial layer (168) is small comparatively with the hole concentration P in the body region (180) (see discussion below). The typical dimensions of the epitaxial layer (168) are (3-10) $\mu$.
In another embodiment of the structure, the semiconductor material (168) is of a second N-conductivity type, has a dopant concentration N⁻⁻ and includes a top surface (182). In this embodiment, the majority carriers are electrons.

A conductive gate (178) overlies the top surface (182) of the semiconductor material. The gate (178) is insulated from the semiconductor material by a gate oxide layer (184). The gate oxide layer has the dimensions (200-700)Å. In one embodiment, the gate comprises a polysilicon gate.

The region (172) forms an enhanced drain drift region of the RF MOS structure. The region (172) is formed completely within the semiconductor material (168). The enhanced drain drift region (172) has N conductivity type (if the epitaxial layer has P conductivity type and vice versa) and has a dopant concentration N. The enhanced drain region increases the drain-to-source breakdown voltage $V_t$ of the RF MOS structure (160). The enhanced drain region (172) has dimensions (0.1-5.0) μ laterally, and about (0.2-0.5) μ vertically.

A drain region (174) is also formed in the semiconductor material (168). The drain region (174) has the N conductivity type (if the epitaxial layer has P conductivity type and vice versa). The drain region (174) has a dopant concentration N⁺ that is greater than the dopant concentration N of the enhanced region (172). The drain region (174) contacts the enhanced region (172). The typical dimensions of the drain region (174) are (0.5-3.0) μ horizontally, and (0.1-0.3) μ vertically.

A body region of the RF MOS structure (180 of FIG. 1E) is also formed in the semiconductor material. The body region (180) has P conductivity type (if the epitaxial layer has P conductivity type and vice versa). The body region has a dopant concentration P that is equal or greater than the dopant concentration P⁻⁻ of the epitaxial layer (168). The body region includes a subregion (181) underlying the conductive gate (178). The remaining portion (183) of the semiconductor material underlying the gate (178) is of P conductivity type (if the epitaxial layer has P conductivity type and vice versa). The typical dimensions of the body region (180) are (0.5- 1.5) μ horizontally or vertically.

The body region (180) includes a source contact region (166) being of N conductivity type N (if the epitaxial layer has P conductivity type and vice versa) and having a dopant concentration N⁺. The typical dimensions of the source contact region (166) are (0.5-1.5) μ horizontally.

The body region (180) also includes a body contact region (164) being of P conductivity type (if the epitaxial layer has P conductivity type and vice versa) and having a dopant concentration P⁺ that is greater than the dopant concentration P of the body region (180). The typical dimensions of the region (164) are (0.5- 1.0) μ vertically or horizontally.

A conductive plug region (162) is formed in the source-body region of the semiconductor material.

In one embodiment, the conductive plug region (162) connects the source region (166) and the body contact region (164) of the semiconductor material to a backside of the RF MOS structure.

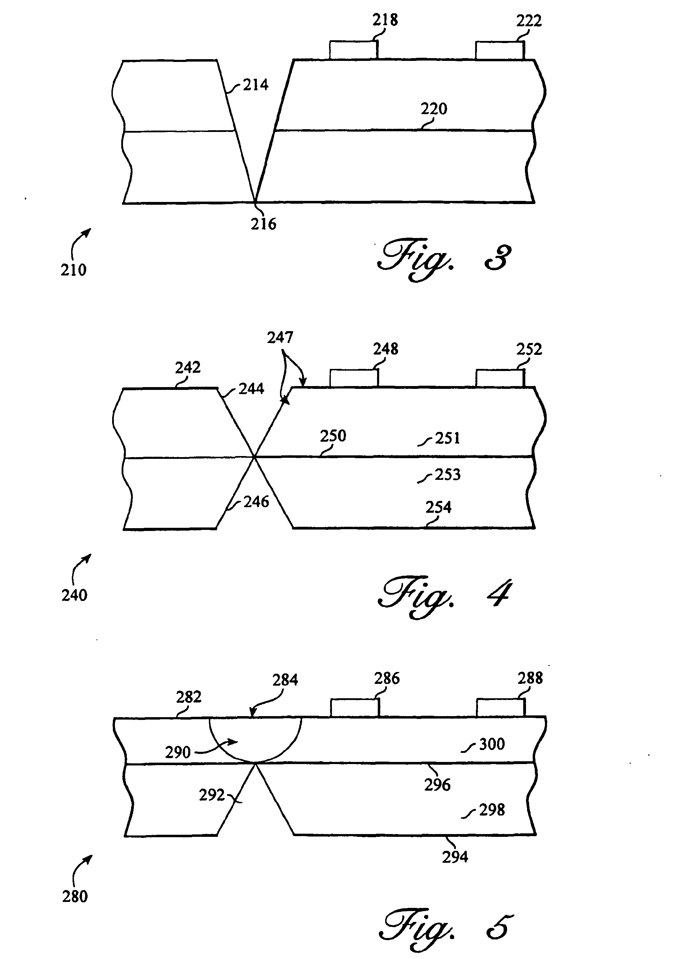

In one embodiment, as depicted in FIG. 3, the conductive plug region (214) connects the top lateral surface (218) of the source region and body contact region (164) to a highly conductive substrate (216) of the RF MOS structure (210).

In another embodiment, as depicted in FIG. 2, the conductive plug region (204) connects a top of the source region and a lateral surface (209) of the body contact region to an interface (206) between a highly conductive substrate (207) of the RF MOS structure and an epitaxial layer (205).

Yet, in one more embodiment, as depicted in FIG. 4, the conductive plug region comprises two elements (244) and (246). The element (244) of the plug connects a top of the source region and a lateral surface (247) of the body contact region to an interface (250) between a highly conductive substrate (254) of the RF MOS structure and an epitaxial layer (251). The element (246) connects the backside (254) of the substrate (253) with the interface (250) between the substrate (253) of the RF MOS structure and the epitaxial layer (251).

The conductive plug structure (160) of FIG. 1E can comprise a metal plug or a silicided plug.

The silicided plug can comprise a tungsten silicided plug, a titanium silicided plug, a cobalt silicided plug, or a platinum silicided plug.

As was stated above, the usage of a conductive plug in the lateral RF MOS transistor structure (160) of FIG. 1E allows one to make a good ohmic contact in a small area of an RF MOS device without having long thermal cycles needed in case of diffusion dopant. Thus, the usage of a conductive plug prevents the increase in the doping movements and betters the usage of the small areas of the MOS device. The better usage of small areas allows a design engineer to increase the density of the RF MOS structures that can be placed per inch².

In the embodiment of the present invention, depicted in FIG. 5, a lateral RF MOS transistor has a structure (280). The structure (280) of FIG. 5 substantially comprises the structure (160) of FIG. 1E with one important difference: the plug (164) of FIG. 1E is replaced with the plug (292) of FIG. 5 and a diffusion region (290).

Therefore, the discussion of the embodiment (280) of FIG. 5 substantially incorporates the given above discussion of the embodiment (160) of FIG. 1E.

However, the additional region (290) requires an additional discussion. The region (290) forms a conductive region of the plug structure. The region (290) has a P conductivity type if the epitaxial layer (300) has a P conductivity type, and vice versa. The region (290) has a dopant concentration that is greater than the dopant concentration of the body region of the RF MOS structure (280) (not shown). The region (290) connects the top and side surfaces (282) of the RF MOS structure (280) to an interface between the highly conductive substrate (298) and the epitaxial layer (300) of the structure (280) of FIG. 5.

The conductive plug region (292) connects a backside (294) of the substrate (298) to the region formed (290) in the semiconductor material of the RF MOS structure.

The conductive plug of the structure (280) of FIG. 5 can also comprise a metal plug or a silicided plug. The silicided plug can comprise a tungsten silicided plug, a titanium silicided plug, a cobalt silicided plug, or a platinum silicided plug.

The usage of a conductive plug (292) in the structure (280) of FIG. 5 also allows one to decrease the dopant area needed for connection of the source of the RF MOS device (284) and the backside (294). Thus, the usage of a conductive plug results in decreased doping area, in decreased doping movements, and in a better usage of the small areas of the RF MOS device. Again, as was stated above, the better usage of small areas allows a design engineer to increase the density of the RF MOS active areas that can be placed per inch$^2$.

As was stated above, the prior art RF MOS transistor includes the BJT interdigitated horizontal geometry with polysilicon fingers (gate), drain contact in the middle, and the source on both sides. In this geometry, the electron current moves form the source (from the bottom) to the drain passing under the gate. The problem with this structure was that the signal current had to feed a very long and narrow gate. The ratio of the length of the gate (50-100) $\mu$ to the width of the gate (1 $\mu$) was about (50-100). The prior art RF MOS transistor utilizes a plurality of long gate fingers having a size of (50-100) squares and a resistivity per square of 20 ($\Omega$/square). This resistivity (20 x 100 = 2,000 $\Omega$) is too high to feed the signal to all portions of the long gate equally because each long finger is connected to a single pick up point.

The RF MOS device of the present invention utilizes a quasi-mesh structure that is disclosed in detail below. The quasi-mesh structure utilizes a plurality of gate areas having dimensions of the order of (13-18) $\mu$ to the side. Thus, instead of the interdigitated structure of the prior art RF MOS transistors, wherein each long gate-finger having size of the order of (50-100) $\mu$ was connected to one gate pick up point, the quasi-mesh structure of the present invention employs a number of relatively short gates (13-18) $\mu$ connected to a plurality of pick up points. (See the detailed description below). Thus, the distance between a typical pick up point and a gate in the quasi-mesh structure of the present invention is up to ten times smaller than the distance between a typical pick up point and a typical long gate in the prior art interdigitated structure.

The silicided long gates employed in the prior art RF MOS transistor can be fed adequately at cellular (900 MHz) frequencies. The RF MOS device of the present invention having a quasi-mesh structure and utilizing relatively short (13-18) $\mu$ polysilicon gates has a resistivity of approximately 200 $\Omega$. Thus, all portions of a typical polysilicon gate can be fed equally at cellular (900 MHz) frequencies. Therefore, the RF MOS device having a quasi-mesh gate structure and utilizing relatively short polysilicon gates has the performance of the prior art RF MOS transistors utilizing the long silicided gates at cellular (900 MHz) frequencies. The benefit of using the RF MOS device with relatively short polysilicon gates instead of using the prior art RF MOS transistor with long silicided gates follows from the fact that the polysilicon gates are easier to fabricate than the silicided gates.

At higher frequencies, in the range of 2 GHz, needed for operation of the personal communication services devices (PCS), the prior art RF MOS transistor including long silicided gates is not adequate because the long silicided gates can not be fed equally at these frequencies. In addition, at high frequencies about 2 GHz, the long finger has not only a resistivity component, but also a sizable capacitance component, that is, the gate acts as a voltage divider.

On the other hand, at high frequencies about 2 GHz, the RF MOS device with quasi-mesh gate structure can utilize the silicided gates instead of polysilicon gates. The silicided gates can be fabricated if a metal like tungsten (Tg), titanium (Ti), cobalt (Co), or platinum (Pl) is put on the polysilicon. If high enough temperature is applied, the metal and the polysilicon mix and form the silicide. The resistivity per square of the silicided gate is significantly decreased comparatively with the polysilicon gate. Indeed, the resistivity per square for the tungsten silicided gate is (2 $\Omega$/square), for the titanium silicided gate is 1 ($\Omega$/square), for the cobalt silicided gate is (1-2) ($\Omega$/square), and for the platinum silicided gate is (1-2) ($\Omega$/square). The short silicided gates can be fed equally at high frequencies up to 2 GHz. Thus, the RF MOS device with quasi-mesh gate structure utilizing short silicided gates can be used at high frequencies about 2 GHz thus surpassing the performance of the prior art RF MOS transistors utilizing the long silicided gates.

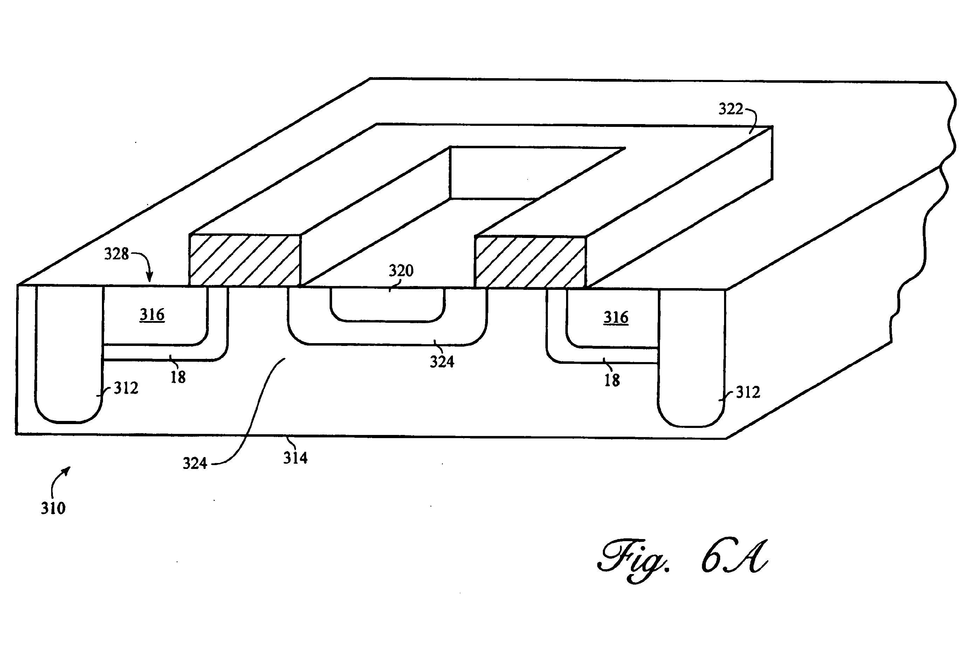

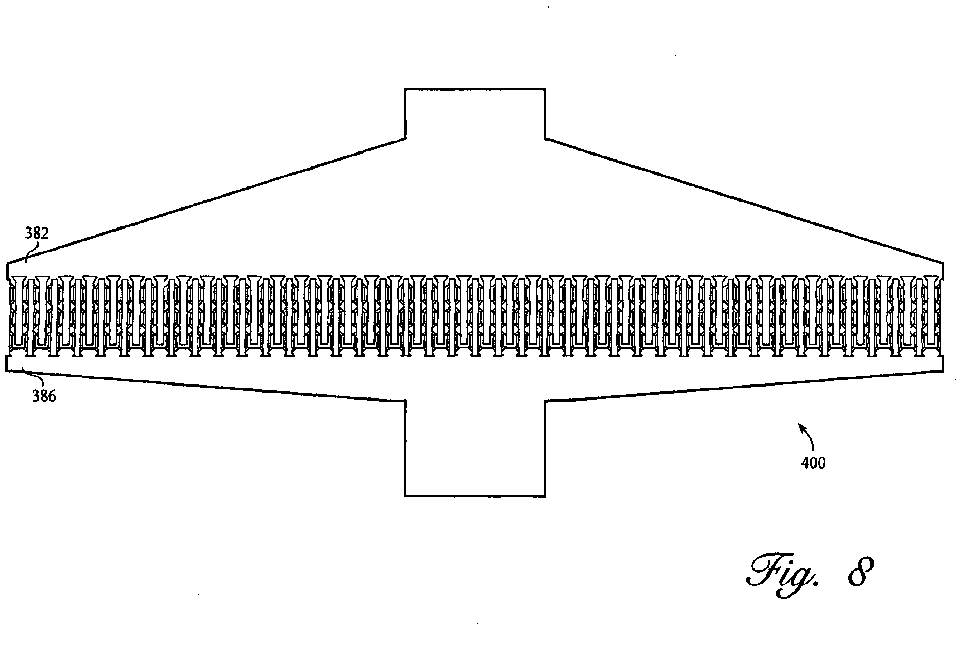

A cross-section of a single RF MOS transistor (310) is depicted in FIG. 6 A. The RF MOS device can include an array of single RF MOS transistors of FIG. 6A, as shown in FIG. 8. See discussion below.

As was described above, the structure (310) of FIG. 6A comprises several layers. The first layer comprises a semiconductor material including an epitaxial layer (324) of a first conductivity type having an epitaxial layer dopant concentration and a top surface (328).

In one embodiment, the epitaxial layer's conductivity type is of a P-type, that is the majority carriers are holes. The dopant concentration of the epitaxial layer is P$^{--}$, wherein (--) indicates that the dopant concentration P$^{--}$ of holes in the epitaxial layer (324) is small comparatively with the hole concentration P in the body region (318). The typical dimensions of the epitaxial layer (324) are (3-10) $\mu$.

In another embodiment of the present invention, the semiconductor material (324) is of a second, N-conductivity type, has a dopant concentration N$^{--}$ and includes a top surface (328). In this embodiment, the majority carriers are electrons.

A conductive gate (322) overlies the top surface (328) of the semiconductor material. The gate (322) is insulated from the semiconductor material by a gate oxide layer (not shown).

In one embodiment, at cellular frequencies, the gate can comprise a polysilicon gate.

In another embodiment, at PCS frequencies, the gate can comprise a silicided gate. (See discussion above). The silicided gate region can comprise: a tungsten silicided gate region, a titanium silicided gate region, a cobalt silicided gate region, or a platinum silicided gate region.

The gate region of a single RF MOS transistor (310), as depicted in FIG. 6A, has the dimensions of (0.5-1.5) μ. The RF MOS device can include an array of single RF MOS transistors of FIG. 6A, as shown in FIG. 8. In the array of single RF MOS transistors, the gate regions form thin finger loop areas having dimensions of the order of (13-15) μ to the side of the loop.

The region (324) forms an enhanced drain drift region of the RF MOS structure. The region (324) can be formed completely within the semiconductor material (324).

The enhanced drain drift region (324) has N conductivity type (if the epitaxial layer has P conductivity type and vice versa) and has a dopant concentration N. The enhanced drain region increases the drain-to-source breakdown voltage $V_t$ of the structure (310). The enhanced drain region (324) has dimensions (0.1-5.0) μ laterally, and about (0.2-0.5) μ vertically.

A drain region (320) is also formed in the semiconductor material (324). The drain region (320) has the N conductivity type (if the epitaxial layer has P conductivity type and vice versa). The drain region (320) has a dopant concentration N$^+$ that is greater than the dopant concentration N of the drain enhanced region (324). The drain region (320 of FIG. 6A) contacts the drain enhanced region (324). The typical dimensions of the drain region (174 of FIG. 1E) are (0.5-3.0) μ horizontally, and (0.1-0.3) μ vertically.

A body region (318) has P conductivity type (if the epitaxial layer has P conductivity type and vice versa). The body region has a dopant concentration P that is equal or greater than the dopant concentration P$^{--}$ of the epitaxial layer (324). The body region includes a subregion (316) underlying the conductive gate (322). The typical dimensions of the body region (318) are (0.5-1.5) μ horizontally or vertically.

The body region (318) includes a source contact region (316) being of N conductivity type N (if the epitaxial layer has P conductivity type and vice versa) and having a dopant concentration N$^+$. The typical dimensions of the source contact region (166 of FIG. 1E) are (0.5- 1.5) μ horizontally.

A conductive plug region (312) is formed in the source region (328) of the semiconductor material.

In one embodiment, the conductive plug region (312) connects the source (328) and body region (318) of the semiconductor material to a backside (314) of the RF MOS structure.

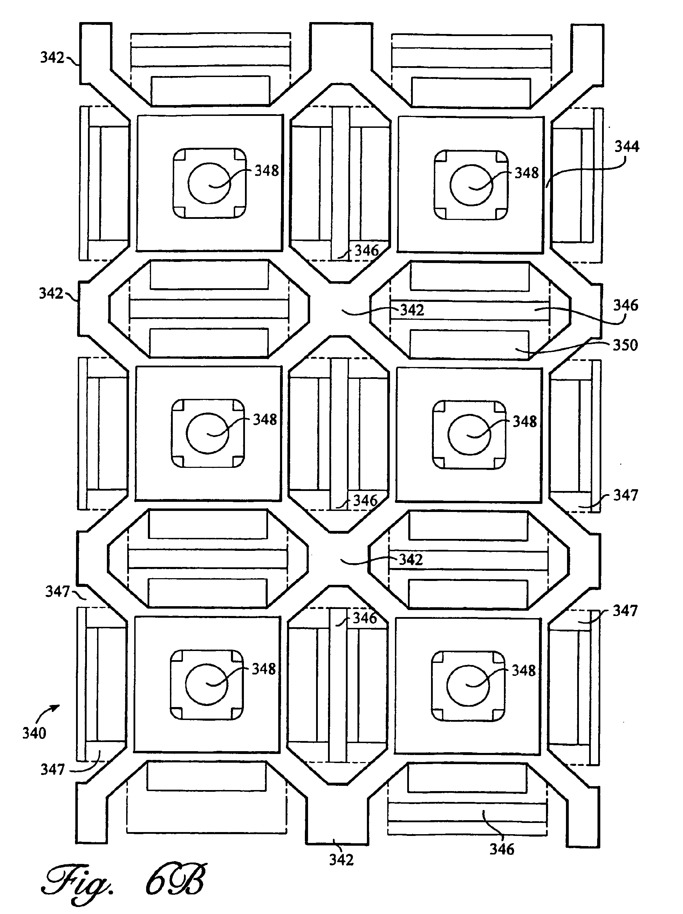

FIG. 6B illustrates a top view of a quasi-mesh gate structure (340) of the RF MOS device which as such does not form part of the claimed invention, showing a plurality of drain regions (348), a plurality of source regions (350) including a plurality of conductive plugs (346), a plurality of separate portions of a conductive gate (344) connected to a plurality of gate pick up points (342), and a plurality of body regions (347).

At least one conductive plug region (346 of FIG. 6B) can comprise a metal plug region or a silicided plug region. The silicided plug region can comprise: a tungsten silicided plug region, a titanium silicided plug region, a cobalt silicided plug region, or a platinum silicided plug region.

Now, we briefly describe a portion of the fabrication process of the quasi-mesh gate structure.

The first metallization process allows one to silicide gates and vias.

After the first metallization process is completed, the dielectric, in the preferred embodiment the silicon dioxide (SiO$_2$), is placed on the top of the gate to cover the gate completely.

The access to drain regions and to gate regions can be open by eliminating dielectric at certain area. The access to source regions or plug regions is not open from the top side of the quasi- mesh structure.

By performing the second metallization process, the two sets of metal fingers can be placed in such a way that a first set of fingers connects all drains on one side of the chip, and a second set of fingers connects all gate pick up points on the other side of the chip.

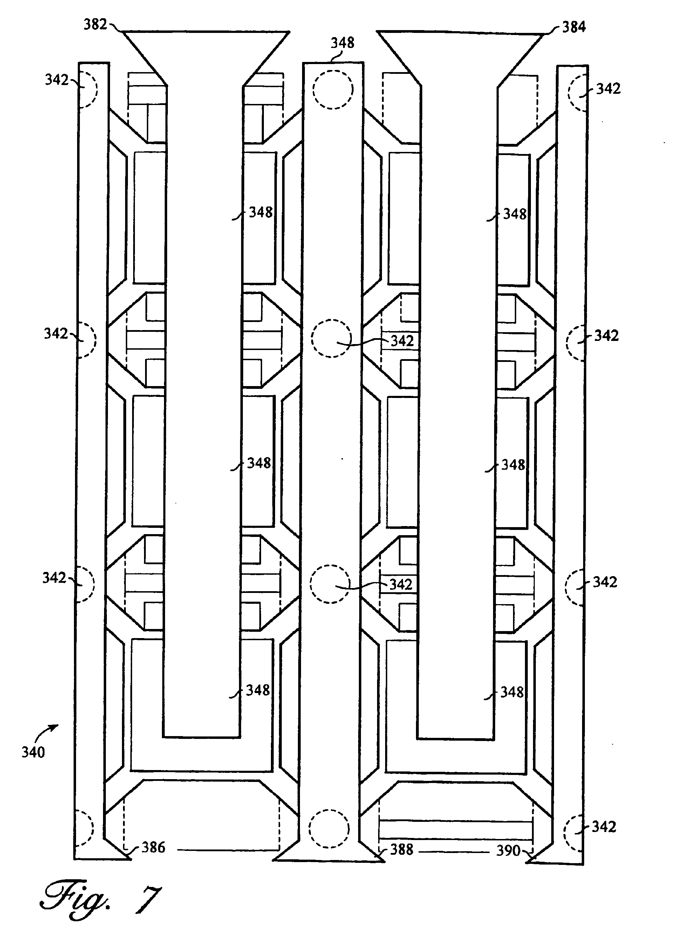

FIG. 7 illustrates an actual top view of the quasi-mesh gate structure (380) of the RF MOS device showing how the first set of metal fingers (382, 384) connects each drain region (348) to a first side of the RF MOS device, and how the second set of metal fingers (388,386, 390) connects each gate pick up point (342) to a second side of the RF MOS transistor.

The top view of the quasi-mesh gate structure, as depicted in FIG. 7, shows that a conductive gate of the whole device includes a plurality of substantially identical gate sites (344).

In one embodiment, each substantially identical gate site can approximate a square shape, as depicted in FIGs. 6B and 7. In another embodiment, each substantially identical gate site can approximate a circular shape. Yet, in one more embodiment, each substantially identical gate site can approximate a diamond shape.

The quasi-mesh gate structure (380) of FIG. 7 also includes a plurality of substantially identical drain regions (348). Each drain region includes a substantially identical drain site.

In one embodiment, each substantially identical drain site can approximate a square shape, as depicted in FIGs. 6B and 7. In another embodiment, each substantially identical drain site can approximate a circular shape. Yet, in one more embodiment, each substantially identical drain site can approximate a diamond shape.

Thus, the quasi-mesh gate structure, as shown in FIG. 7, results in a dense array of sources, gate loops, and drain regions. The quasi-mesh gate structure of the present invention enables the gate loop regions to be smaller as compared with the long gates used in the prior art RF MOS device. Thus, the RF MOS device of the present invention having the quasi-mesh gate structure enables smaller resistivity of the gates and betters feeding of all portions of the gate structure at high frequencies.

The metal fingers connect all the drain and gate contacts at the end and direct the currents to pads where bonding wires, bumps or other packaging means take the signals to the rest of the outside circuit.

An actual top view of the complete transistor array (400) is shown in FIG. 8. The size of the transistor array can be selected to achieve virtually any RF current handling capacity.

The description of the preferred embodiment of this invention is given for purposes of explaining the principles thereof, and is not to be considered as limiting or restricting the invention since many modifications may be made by the exercise of skill in the art without departing from the scope of the invention.

**Claims**

1. A lateral RF MOS transistor having a plug connective structure (160, 280), comprising:

   a highly conductive substrate (298);
   a semiconductor material (168, 300) of a first conductivity type formed as an epitaxial layer on said conductive substrate (298), said semiconductor material (168, 298) having a first dopant concentration (P--) and a top surface (182, 282);
   a conductive gate (178) overlying and insulated from said top surface of said semiconductor material (168, 300);
   a first region (172) formed completely within said semiconductor material (168, 300) of said first conductivity type, said first region (172) being of a second conductivity type and having a second dopant concentration (N) to form an enhanced drain drift region of said RF MOS transistor structure;
   a second region (174) formed in said semiconductor material (168, 300), said second region (174) being of said second conductivity type and having a third dopant concentration (N+) greater than said second dopant concentration (N) to form a drain region of said RF MOS transistor, said second region (174) contacting said first region (172);
   a third region (180; 181) formed in said semiconductor material (168, 300), said third region being of said first conductivity type and having a fourth dopant concentration to form a body region of said RF MOS transistor structure, said fourth dopant concentration being equal or greater than said first dopant concentration (P--), said third region having a first end underlying said conductive gate (178), any remaining portion (183) of said semiconductor material underlying said gate (178) being of said first conductivity type;
   a fourth region (166) formed in said semiconductor material (168, 300), said fourth region (166) being of said second conductivity type and having a fifth dopant concentration (N+) to form a source region of said RF MOS transistor structure, said fourth region (166) being located within said third region;
   a fifth region (164) formed in said semiconductor material (168, 300), said fifth region being of said first conductivity type and having a sixth dopant concentration (P+) to form a contact enhancement region of said RF MOS transistor structure, said sixth dopant concentration (P+) being greater than said fourth dopant concentration of said third region, said fifth region (164) being located within said third region (180);
   a sixth region (290) formed in said semiconductor material (168, 300), said sixth region (290) being of said first conductivity type and having a seventh dopant concentration to form a contact region of said lateral RF MOS transistor structure (160, 280), said seventh dopant concentration being greater than said fourth dopant concentration of said third region, said sixth region (290) contacting said third region, said sixth region (290) connecting said top surface (282) of said semiconductor material (168, 300) to said highly conductive substrate (298); and
   a conductive plug region (292) connecting a backside (294) of said semiconductor material (168, 300) to said sixth region (290).

2. The lateral RF MOS transistor structure of claim 1, wherein said first conductivity type is a P type.

3. The lateral RF MOS transistor structure of claim 1 wherein said conductive plug (292) comprises a metal plug, a silicided plug, a tungsten silicided plug, a titanium silicided plug, a cobalt silicided plug, or a platinum silicided plug.

**Patentansprüche**

1. Lateraler HF-MOS-Transistor mit einer Steckerverbindungsstruktur (160, 280), welcher aufweist:

ein stark leitendes Substrat (298);
ein Halbleitermaterial (168, 300) eines ersten Leitfähigkeitstyps, das als Epitaxialschicht auf dem leitenden Substrat (298) ausgebildet ist, wobei das Halbleitermaterial (168, 298) eine erste Dotierungskonzentration (P--) und eine obere Oberfläche (182, 282) aufweist;
ein leitendes Gate (178), das über der oberen Oberfläche des Halbleitermaterials (168, 300) liegt und von dieser isoliert ist;
einen ersten Bereich (172), der vollständig innerhalb des Halbleitermaterials (168, 300) des ersten Leitfähigkeittyps ausgebildet ist, wobei der erste Bereich (172) von einem zweiten Leitfähigkeittyp ist und eine zweite Dotierungskonzentration (N) aufweist, um einen verstärkten Draindriftbereich der HF-MOS-Transistorstruktur auszubilden;
einen zweiten Bereich (174), der in dem Halbleitermaterial (168, 300) ausgebildet ist, wobei der zweite Bereich (174) vom zweiten Leitfähigkeittyp ist und eine dritte Dotierungskonzentration (N+) aufweist, die größer ist als die zweite Dotierungskonzentration (N), um einen Drainbereich des HF-MOS-Transistors auszubilden, wobei der zweite Bereich (174) mit dem ersten Bereich (172) in Kontakt steht;
einen dritten Bereich (180; 181), der in dem Halbleitermaterial (168, 300) ausgebildet ist, wobei der dritte Bereich vom ersten Leitfähigkeittyp ist und eine vierte Dotierungskonzentration aufweist, um einen Körperbereich der HF-MOS-Transistorstruktur auszubilden, wobei die vierte Dotierungskonzentration gleich der oder größer als die erste Dotierungskonzentration (P--) ist, wobei der dritte Bereich ein erstes Ende aufweist, das unter dem leitenden Gate (178) liegt, wobei irgendein restlicher Teil (183) des Halbleitermaterials, der unter dem Gate (178) liegt, vom ersten Leitfähigkeittyp ist,
einen vierten Bereich (166), der in dem Halbleitermaterial (168, 300) ausgebildet ist, wobei der vierte Bereich (166) vom zweiten Leitfähigkeittyp ist und eine fünfte Dotierungskonzentration (N+) aufweist, um einen Sourcebereich der HF-MOS-Transistorstruktur auszubilden, wobei der vierte Bereich (166) innerhalb des dritten Bereichs liegt;
einen fünften Bereich (164), der in dem Halbleitermaterial (168, 300) ausgebildet ist, wobei der fünfte Bereich vom ersten Leitfähigkeitstyp ist und eine sechste Dotierungskonzentration (P+) aufweist, um einen Kontaktverbesserungsbereich der HF-MOS-Transistorstruktur auszubilden, wobei die sechste Dotierungskonzentration (P+) größer ist als die vierte Dotierungskonzentration des dritten Bereichs, wobei der fünfte Bereich (164) innerhalb des dritten Bereichs (180) liegt;
einen sechsten Bereich (290), der in dem Halbleitermaterial (168, 300) ausgebildet ist, wobei der sechste Bereich (290) vom ersten Leitfähigkeitstyp ist und eine siebte Dotierungskonzentration aufweist, um einen Kontaktbereich der lateralen HF-MOS-Transistorstruktur (160, 280) auszubilden, wobei die siebte Dotierungskonzentration größer ist als die vierte Dotierungskonzentration des dritten Bereichs, wobei der sechste Bereich (290) mit dem dritten Bereich in Kontakt steht, wobei der sechste Bereich (290) die obere Oberfläche (282) des Halbleitermaterials (168, 300) mit dem stark leitenden Substrat (298) verbindet; und
einen leitenden Steckerbereich (292), der eine Rückseite (294) des Halbleitermaterials (168, 300) mit dem sechsten Bereich (290) verbindet.

2. Laterale HF-MOS-Transistorstruktur nach Anspruch 1, wobei der erste Leitfähigkeitstyp ein P-Typ ist.

3. Laterale HF-MOS-Transistorstruktur nach Anspruch 1, wobei der leitende Stecker (292) einen Metallstecker, einen mit Silizid beschichteten Stecker, einen mit Wolframsilizid beschichteten Stecker, einen mit Titansilizid beschichteten Stecker, einen mit Kobaltsilizid beschichteten Stecker oder einen mit Platinsilizid beschichteten Stecker aufweist.

**Revendications**

1. Transistor Métal - Oxyde - Semiconducteur HF latéral possédant une structure de fiche de connexion (160, 280), comprenant :

un substrat hautement conducteur (298);

un matériau semi - conducteur (168, 300) présentant un premier type de conductivité, qui est formé comme une couche épitaxiale sur ledit substrat conducteur (298), ledit matériau semi - conducteur (168, 298) possédant une première concentration en élément dopant (P--) et une surface supérieure (182, 282) ;

une porte conductrice (178), qui recouvre ladite surface supérieure dudit matériau semi - conducteur (168, 300) et qui en est isolée ;

une première région (172), qui est entièrement formée à l'intérieur dudit matériau semi conducteur (168, 300) présentant ledit premier type de conductivité, ladite première région (172) présentant un deuxième type de conductivité et possédant une deuxième concentration en élément dopant (N) pour former une région de caisson de drain maximale de ladite structure de transistor Métal - Oxyde - Semiconducteur HF ;

une deuxième région (174), qui est formée dans ledit matériau semi - conducteur (168, 300), ladite deuxième région (174) présentant ledit deuxième type de conductivité et possédant une troisième concentration en élément dopant (N+), qui est supérieure à ladite deuxième concentration en élément dopant (N), pour former une région de drain dudit transistor Métal - Oxyde - Semiconducteur HF, ladite deuxième région (174) contactant ladite première région (172);

une troisième région (180 ; 181), qui est formée dans ledit matériau semi - conducteur (168, 300), ladite troisième région présentant ledit premier type de conductivité et possédant une quatrième concentration en élément dopant pour former une région corporelle de ladite structure de transistor Métal - Oxyde - Semiconducteur HF, ladite quatrième concentration en élément dopant étant égale ou supérieure à ladite première concentration en élément dopant (P--), ladite troisième région possédant une première extrémité sous - jacente par rapport à ladite porte conductrice (178), toute portion restante (183) dudit matériau semi-conducteur sous - jacente par rapport à ladite porte (178) présentant ledit premier type de conductivité ;

une quatrième région (166), qui est formée dans ledit matériau semi - conducteur (168, 300), ladite quatrième région (166) présentant ledit deuxième type de conductivité et possédant une cinquième concentration en élément dopant (N+) pour former une région de source de ladite structure de transistor Métal - Oxyde - Semiconducteur HF, ladite quatrième région (166) étant située à l'intérieur de ladite troisième région ;

une cinquième région (164), qui est formée dans ledit matériau semi - conducteur (168, 300), ladite cinquième région présentant ledit premier type de conductivité et possédant une sixième concentration en élément dopant (P+) pour former une région d'amélioration de contact de ladite structure de transistor Métal - Oxyde - Semiconducteur HF, ladite sixième concentration en élément dopant (P+) étant supérieure à ladite quatrième concentration en élément dopant de ladite troisième région, ladite cinquième région (164) étant située à l'intérieur de ladite troisième région (180) ;

une sixième région (290), qui est formée dans ledit matériau semi - conducteur (168, 300), ladite sixième région (290) présentant ledit premier type de conductivité et possédant une septième concentration en élément dopant pour former une région de contact de ladite structure de transistor Métal - Oxyde - Semiconducteur HF latéral (160, 280), ladite septième concentration en élément dopant étant supérieure à ladite quatrième concentration en élément dopant de ladite troisième région, ladite sixième région (290) contactant ladite troisième région, ladite sixième région (290) connectant ladite surface supérieure (282) dudit matériau semi - conducteur (168, 300) avec ledit substrat hautement conducteur (298) ; et

une région de fiche de connexion (292) connectant une face dorsale dudit matériau semi - conducteur (168, 300) avec ladite sixième région (290).

2. Transistor Métal - Oxyde - Semiconducteur HF latéral selon la revendication 1, dans lequel ledit premier type de conductivité est un type P.

3. Transistor Métal - Oxyde - Semiconducteur HF latéral, dans lequel ladite fiche de connexion (292) comprend une fiche en métal, une fiche en siliciure, une fiche en siliciure de tungstène, une fiche en siliciure de titane, une fiche en siliciure de cobalt ou une fiche en siliciure de platine.

EP 1 058 949 B1

VGS

26

20    18

24    22

N+    N+

12    16

L

28

14

*Fig. 1A*

G

56

VGS    42    54    52    50

48

46

S

44

*Fig. 1B*    40

B

*Fig. 3*

*Fig. 4*

*Fig. 5*

*Fig. 1E*

160

*Fig. 2*

200

## Fig. 1C

62 66 68 70 72
N+ N- N+
P+ P- 74
64 P--
75
P++
76
78

60

## Fig. 1D

82 86 88 90 72
84 N+ N- N+
P- 92
P-- 94
95
P++
96
78

80

*Fig. 6A*

EP 1 058 949 B1

*Fig. 6B*

*Fig. 7*

Fig. 8

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4408384 A
- US 5155563 A
- US 4803539 A
- JP 63055960 A

**Non-patent literature cited in the description**

- **PAUL GRAY ; ROBERT MEYER.** Analysis and Design of Analog Integrated Circuits. John Wiley & Sons, Inc, 1993